Europäisches Patentamt

(19) European Patent Office   (11) Publication number: **0 057 314**
Office européen des brevets                              **B1**

(12)                    **EUROPEAN PATENT SPECIFICATION**

(45) Date of publication of patent specification: **04.12.85**   (51) Int. Cl.⁴: **H 03 K 23/52**, G 09 G 1/16

(21) Application number: **81304891.5**

(22) Date of filing: **20.10.81**

(54) **LSI timing circuit for a digital display employing a modulo eight counter.**

(30) Priority: **28.01.81 US 229210**

(43) Date of publication of application:
**11.08.82 Bulletin 82/32**

(45) Publication of the grant of the patent:
**04.12.85 Bulletin 85/49**

(84) Designated Contracting States:
**BE DE FR GB IT NL**

(56) References cited:
**EP-A-0 017 091**
**US-A-3 371 282**
**US-A-3 515 341**

**COMPUTER DESIGN, vol. 11, no. 11, November 1972, CONCORD, Mass. (US), A. MESSINA: "Considerations for Non-Binary Counter Applications", pages 99-104**
**IBM TECHNICAL DISCLOSURE BULLETIN, vol. 17, no. 8, January 1975, NEW YORK (US), PASKA: "High-Frequency Shift Register Circuitry", pages 2407-2409**

(73) Proprietor: **BURROUGHS CORPORATION (a Michigan corporation)**
**Burroughs Place**
**Detroit, Michigan 48232 (US)**

(72) Inventor: **Wu, Ta-Ming**
**13313 Thunderhead Street**
**San Diego California 92129 (US)**
Inventor: **Gaertner, Gregory Edward**
**17547 Caminito Heno**
**San Diego California 92127 (US)**

(74) Representative: **Kirby, Harold Douglas Benson et al**
**G.F. Redfern & Company Marlborough Lodge 14 Farncombe Road**
**Worthing West Sussex BN11 2BT (GB)**

Courier Press, Leamington Spa, England.

## Description

Background of the invention
Field of the invention

This invention relates to a timing circuit for controlling a digital display.

Description of the prior art

In order to reduce the manufacturing costs of the circuitry for a digital display unit, it is desirable to achieve as many functions on a single integrated circuit chip as permissible, either by increasing the packing density of the gates in the chip or by novel circuit designs and architecture creation. This in turn leads to wider use of the digital display units to in turn accommodate more applications for information processing systems.

Such digital display units may be custom made or may be formed of conventional commercial television sets. In either case, the information displayed is usually of the nature of characters formed of dot matrix where the display unit employs a raster scan mode. Each horizontal line is divided into a number of discrete points or areas called picture elements (PELS) or pixels. A fraction of such picture elements per line is not employed for information display but is that portion of the scan time required for horizontal retrace and synchronization of the horizontal oscillator.

As the display screen is scanned, the dot matrix characters are formed by character generation circuits that control the modulation of the electron beam (in the case of CRT displays), individual circuits of which are selected by character codes that are stored in the memory. The code store can be a shift register with exactly the same number of cells as there are character positions on the display screen, or it may be a random access memory.

In some display units, 25 to 30 complete scans of all the lines making up the display are made per second. Thus, each portion of a character being displayed is on display 25 to 30 times a second for a brief period and this can cause an apparent flickering. The flickering problem is normally solved by refreshing or redrawing all the lines in the display in two consecutive interlaced scans. A "half-scan" is redrawn or refreshed in half the time. Because of the 2:1 interlace between the two half-scans, if a horizontal line is drawn in one half-scan and is adjacent to a line drawn in the next half-scan, the two form a line on the display screen with reduced flicker because, in essence, it is written twice as often. Applying this knowledge, a 6×8 dot matrix character can be displayed on a 12×16 dot matrix, by displaying each dot in the 6×8 matrix four times. This reduces flicker considerably, as the character now seems to be written 50 to 60 times a second, instead of 25 to 30 times.

In modern practice, the character generation circuits and the code stores are implemented in integrated circuitry where care must be given to the number of gates and resultant capacitance involved so as to allow the circuitry to operate at very high speed to generate the appropriate signals to drive the display. Such integrated circuitry is driven by a clock with the appropriate timing signals required for the synchronization of the respective horizontal and vertical scans and retrace being created by a counter which counts the number of time intervals required for restarting the various scans and other events.

In the past, such a counter has been a binary counter which employs a number of gates so as to make it difficult to implement for operation at very high speeds.

It is then an object of the present invention to provide an improved timing circuit for a digital display unit.

It is another object of the present invention to provide an improved timing circuit for a digital display unit which can be implemented with a reduced number of gates and thus reduce circuit delays.

Still another object of the present invention is to provide an improved timing circuit that can be implemented on an integrated circuit chip for operation at very high speeds.

The present invention consists in a timing circuit for controlling a digital display, said timing circuit including a counter comprising a plurality of counter stages coupled in series, each of said plurality of counter stages including four commonly-clocked cells coupled in series and each earlier counter stage in the series providing a common clocking signal to the next later counter stage in the series only when said earlier counter stage has progressed in its count from zero to seven, said counter further comprising decoding circuitry coupled to receive outputs from said cells in said counter stages, said decoding circuitry being required to monitor two outputs from said cells in each counter stage of said counter in order uniquely to decode any one count of said counter, said timing circuit being characterised by said counter being operable to provide a sequence of counts representative of a sequence of positions of a scanning operation along a line of characters in said digital display, said decoding circuitry comprising a plurality of decoders, each operable to decode a first respective predetermined count of said counter for setting a respective flip-flop for said respective flip-flop to provide a respective one of a corresponding plurality of control signals to said display and each decoder being further operable to decode a second respective predetermined count of said counter for resetting said respective flip-flop for said respective flip-flop to cease providing said respective one of said plurality of control signals to said display, said each decoder of said decoding circuitry being coupled to receive less than said two outputs from said cells in said each counter stage required uniquely to identify said second respective predetermind count, for said respective flip-flop repeatedly to be reset during the course of said scanning operation without alteration to the function thereof which would be obtained if said second respective predetermined count were uniquely decoded by said respective flip-flop remaining reset after the initial instance of its being reset.

The invention also provides a method for controlling a digital display using the timing circuit described above.

In an article titled "Considerations for Non-Binary Counter Applications" by Messina in Computer design, Volume 11, No. 11 of November 1972, there is disclosed the use of cascaded Johnson and pseudo-Johnson counter stages to form a larger counter. Each of the stages is resettable upon detection of a predetermined overall count to provide the maximum count for the whole counter. Each of the stages is characterized by requiring the monitoring of only two outputs from its many cells to determine its count. Messina further discloses the gating of a clock signal by an earlier Johnson stage to a later Johnson counter stage only when the earlier Johnson counter stage has reached its maximum count. The present invention seeks to improve over the disclosed use of Johnson and pseudo-Johnson counters by Messina by reducing the complexity of decoding yet further below that disclosed by Messina. The present invention requires fewer than two outputs to be decoded from each Johnson counter stage thereby reducing the component count and increasing the speed of the decoding operations.

Description of the drawings

The above and other objects, advantages and features of the present invention will become more readily apparent from a review of the following disclosure when taken in conjunction with the drawings wherein:

Figure 1 is a representation of a system employing the present invention;

Figures 2A—C illustrate characters that can be displayed by the system of Figure 1;

Figure 3 is a representation of buffer and output circuitry of the system of Figure 1;

Figure 4 is a representation of the timing circuitry of Figure 3;

Figure 5 illustrates waveforms generated by the present invention;

Figures 6A and B are diagrams representing a portion of the present invention;

Figure 7 is a schematic diagram of a counter used in the present invention; and

Figure 8 is a schematic diagram of a stage of Figure 7.

General description of the invention

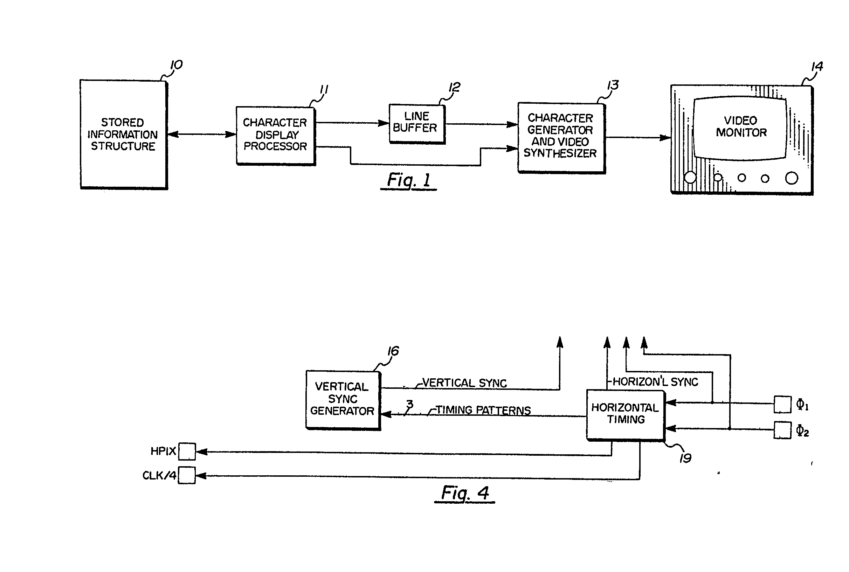

A digital display system of the type employing the present invention is illustrated in Figure 1. As shown therein, stored information structures are fetched from information storage 10 by character display processor 11 which controls the communication between storage 10 and the video output circuit employing the present invention. Character codes from the display processor 11 are received by line buffer 12 for sequential presentation to the video output circuit 13. As indicated in Figure 1, video output circuit 13 includes both the character generation circuitry and the video synthesization circuitry. The system of the present invention is adapted to provide video signals to a commercial video monitor 14.

The picture on the display monitor 14 is refreshed or redrawn a number of times per second, 25 to 30 times per second in the system in which the present system resides. For this reason, there has to be storage for the information to be displayed during each scan of the display. Line buffer 12 of Figure 1 provides this capability. The display area of the television screen can be divided into a coordinate system which in the system being described, has 640 picture elements on a horizontal line and 480 lines in a picture. As will be more fully described below, the timing sequence provides for an additional 140 picture elements to accommodate the retrace portion of the scan cycle. If a chosen character set were to contain, for example, characters 8 picture elements wide and 16 lines high, the character position counter would divide the screen into 80 character positions horizontally and 30 character lines vertically for an 80×30=2,400 characters to be displayed.

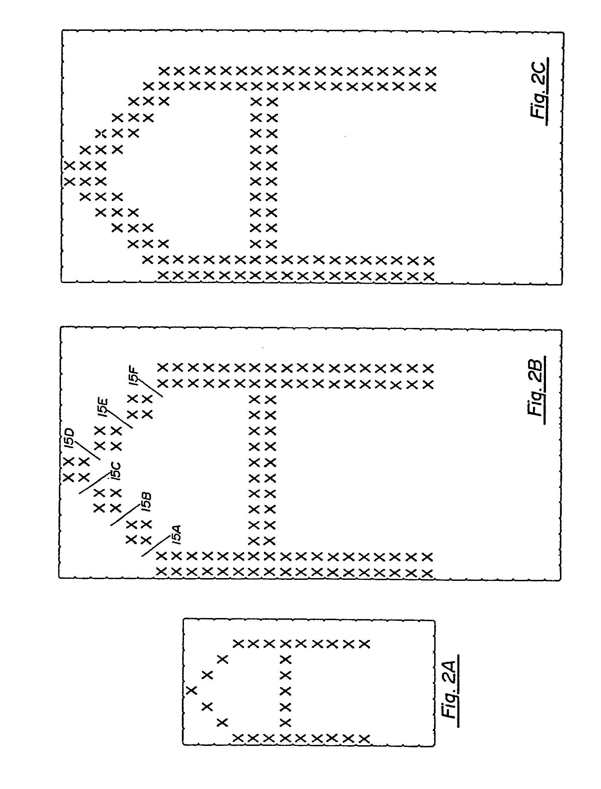

The character generator generates the signals for each character dot-matrix pattern. For a brief explanation of this pattern, reference is now made to Figure 2A which illustrates as an example, the dot-matrix pattern for the letter "A". The dot-matrix, in this example, is an area of 16 rows of 8 picture elements each. The character "A" is defined by those areas marked by "X's" which represent the picture element on the display screen that will be activated during the character generation or appear as light dots on the display screen with the blank areas in Figure 2A representing dark dots or inactivated areas. The character created on the display screen is represented by the dark and light areas according to the character pattern.

As was indicated above, it is common to employ an interlaced scan in a commercial television display to reduce the flickering of that information as it is seen by the viewer. To this end, the individual character information generated by the character generator circuitry is displayed four times. Thus, an 8×16 character such as illustrated in Figure 2a becomes a 16×32 character dot-matrix as illustrated in Figure 2B. Figure 2B appears to be ragged because of the lack of informational bits as illustrated in Figure 2B or they are denoted by diagonal lines 15A—F. Because of the display of each informational bit four times, this results in the exclusion of "included" corners. As described in the Seitz et al U.S. Patent No. 4,119,954, circuitry can be provided to supply informational bits to adjacent areas whenever "included" corners are to occur. This results in the display of a character as illustrated in Figure 2C.

The video output circuit employing the present invention can generate four character sizes depending upon two status bits, high and wide, of the status code which precedes the character code and specifies the mode in which the character is to be displayed. If both of these bits are 0, a normal sized character with 8 columns and 16 rows is generated. If the wide bit equals one, a double-width character is produced. When both the high and wide status bits equal one, a character of 32 rows and 16 columns is generated.

A row address is also provided to the video output circuitry to specify the start of each horizontal line. The row address is used with the status bits for highlights: superscript, subscript, and high, to determine which horizontal row of the character font is output for the present scan line. Other highlights can be specified by appropriate bits in the status code. The Bright and Reverse bits control the intensity levels assigned to the foreground and the background shades. These four combinations include various combinations of gray, black, and white for both the foreground and the background. When the Underline status bit is set, the two scan lines below the character are set to the foreground shade for that character. The Blank or Invisible bit causes the entire character, including the Underline, to be displayed as a background shade. When the Secure bit is set, all pixels within the character area are displayed as a foreground shade. This highlight has no effect outside of the character area, or if the Blank bit is enabled. Finally, the setting of the cursor bit reverses all pixels within the character area, i.e., pixels of the background shade are displayed as foreground shade and vice versa.

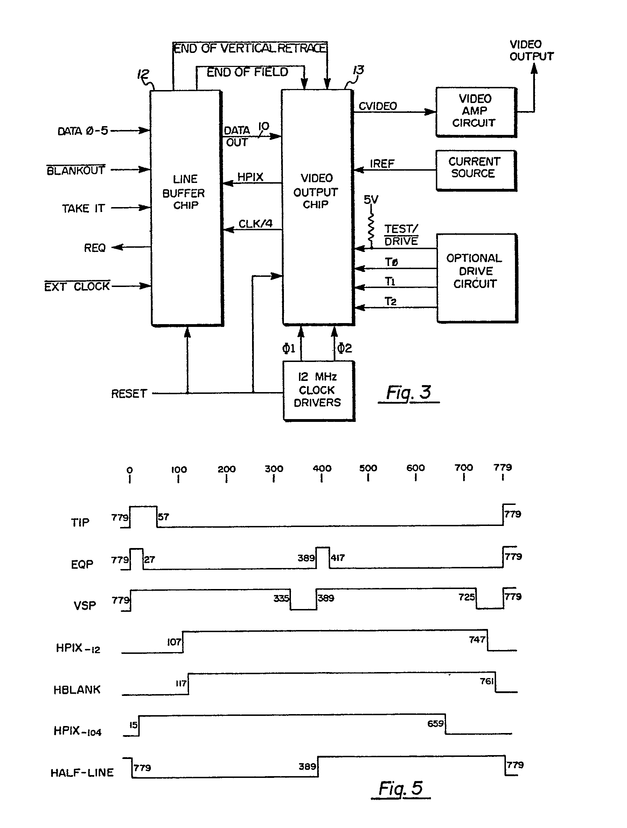

Figure 3 illustrates the signals that the line buffer circuit and the video output circuit employ to communicate with the rest of the system and with each other. The rate at which the 17 input signals, DATA 1—15, and BLANKOUT are shifted into the circuit is dependent upon both frequency of the external clock and the readiness of the line buffer circuit to accept new data. The readiness is characterized by the state of the REQUEST (REQ) signal. On the output side of the circuit, information is transferred to the video output circuit in 10-bit quantities at a rate exactly equal to the pixel rate divided by four. Synchronization with the video monitor is made possible through the horizontal sync signal HPIX whose main purpose is to bracket the activity part of the video scan line. The RESET line shown in Figure 3 is common to the whole video system of synchronization during power-up. Finally, two other output leads are assigned to the END FIELD and END OF VERTICAL RETRACE signals.

The storage or line buffers are implemented by two 80×20 sequentially accessed memories. Each 20-bit word fully describes one of the 80 displayable characters. Eight bits of the character code address the character font of the video output circuit to select one of 256 characters, along with two "Font Select" bits to allow selection of a particular video output circuit. Ten bits of the status (or "highlight") information contribute to the general appearance of the character such as its size, brightness, position relative to the character line, background shade, and so forth.

Given a particular character line, the same sequence of 80 pairs of data is sent to the video output circuit for each scan line. These 160 transfers take place within 160 clock/four periods, and are preceded by a 10-bit row address which specifies which row of the character dot-matrix is to be displayed on the present scan line.

The data must be read from the line buffer a number of times equal to the scan line pairs for that particular character line. At the end of every scan line, the register holding the row address is incremented and points to the next scan to be displayed.

Communication on the input side of the line buffer circuit is attained by two signals, REQUEST and TAKE IT. When the line buffer circuit is empty and can accept a new character, it raises its REQUEST signal and keeps it high until TAKE IT signal goes high, at which time a new set of data on the data input lines is strobed into the line buffer. At this time, the line buffer circuit is able to process that particular character immediately and keeps its REQUEST signal high for another clock period, indicating it can process a second character right away. However, no more than two characters can be processed consecutively. At this time, the line buffer circuit is unable to process another character. This is characterized by the REQUEST signal going low after the second set of data as been strobed in.

Because of the nature of the video signal production, and its need to be compatible with television standards, the output signals of the system must be supplied constantly at the video frequency.

The video output circuit of Figure 3 receives data signals that are either a row address, a status code, or a character code which are employed to specify the character to be displayed, the scan line at which the display is to start and various highlights of the display of the character. The synchronization circuitry of Figure 3 is illustrated in more detail in Figure 4 and includes the vertical sync generator 16 and horizontal timing circuitry 19. Vertical sync generator 16 examines a row address register. If the two high order bits of the register have been set, vertical sync generator 16 generates the vertical retrace sequence for the timing patterns provided by horizontal timing circuitry 19. In addition, horizontal timing circuitry 19 generates horizontal sync signals for the video output circuit and the respective HPIX and clock/four timing signals for the line buffer circuitry. Horizontal timing circuitry 19 also generates additional signals which are employed by various portions of the video output circuit.

Detailed description of the invention

As was indicated above, the present invention is adapted for employment with a standard commercial video monitor wherein each horizontal scan line will contain 640 picture elements or pixels with an additional 140 pixel time elements being employed for the retrace portion of the scan for a total of 780 pixel time elements per scan. The timing signals required for each scan are illustrated in Figure 5 and are adapted to conform to EIA Electrical Performance Standards for Monochrome Television Facilities, RS-170. As illustrated in Figure 5, seven waveforms are required to be generated by the timing generator of the present invention. They are the horizontal sync pulse TIP; the equalization pulses EQP; the vertical sync pulses VSP; two horizontal sync signals HPIX, one of which is employed to drive the line buffer of Figure 3 and the other which is employed to drive the video output circuitry; the horizontal blank signal $\overline{\text{HBLANK}}$; and the half-line signal HALFLINE. These signals will not be discussed in detail at this time except to indicate that, in Figure 5, they are to begin and end at a different number of pixel time units, which values are a matter of design criteria. Suffice it to say that out of the 780 pixel time elements required for each horizontal scan, the respective signals are to be generated at specific times which require specific decoding circuitry. The particular specific times are listed as follows:

| Decimal | Octal | Decodes | | | | |
|---|---|---|---|---|---|---|
| 117 | 0165 | | $A_2$ | $\overline{B_1}$ $C_1$ | $\overline{A_0}$ $B_0$ | |
| 761 | 1371 | E $C_2$ | | $\overline{C_1}$ $D_1$ | $A_0$ | |
| 779 | 1413 | E | | $D_2$ $A_1$ | $C_0$ | |
| 57 | 0071 | | | $\overline{C_1}$ $D_1$ | $A_0$ | |
| 15 | 0017 | $\overline{\overline{E}}$ | | $A_1$ | $\overline{C_0}$ $D_0$ | |
| 659 | 1223 | E $B_2$ | | $B_1$ | $C_0$ | |
| 107 | 0153 | $\overline{E}$ $A_2$ | | $\overline{A_1}$ $B_1$ | $C_0$ | |
| 747 | 1353 | E $C_2$ | | $\overline{A_1}$ $B_1$ | $C_0$ | |
| 389 | 0605 | $\overline{B_2}$ $C_2$ | | $\overline{D_1}$ $\overline{A_0}$ | $B_0$ | |
| 417 | 0641 | $\overline{B_2}$ $C_2$ | | $D_1$ $A_0$ | | |
| 27 | 0033 | $\overline{C_2}$ | | $C_1$ | $C_0$ | |
| 335 | 0517 | $\overline{A_2}$ $B_2$ $A_1$ | | $\overline{C_0}$ $D_0$ | | |
| 725 | 1325 | E $C_2$ | | $B_1$ | $\overline{A_0}$ $B_0$ | |
| 370 | 0562 | $\overline{A_2}$ $B_2$ $\overline{B_1}$ $C_1$ $B_0$ | | | | |
| 4 | 0004 | $\overline{E}$ $\overline{D_2}$ | | | $D_0$ | |

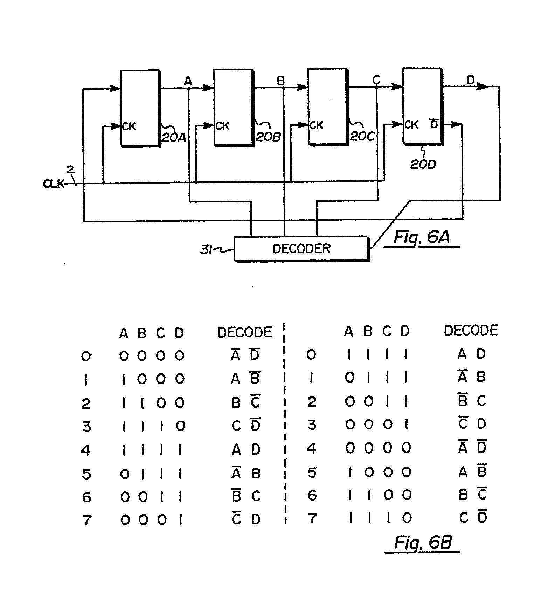

In prior art timing circuit, a binary counter was employed which, nevertheless, required a large number of gates if it were to count to a relatively high number such as 780. In the present invention, a series of modulo eight Johnson-type counters are employed wherein each counter in the series counts from 0 to 7 before triggering the next order counter. The basic building block of such a counter is illustrated in Figure 6A and shows a series of cells 20A . . . D, each of which is driven by a clock during each clock time. The order of sequence for the respective stages is illustrated in Figure 6B. As shown therein, on the first clock period cell 20A will switch to the true state and remain there until reset by the false output of cell 20D. Correspondingly, cell 20B will switch to the true state on the second clock pulse and remain there until reset, and so forth. The outputs of the respective cells could be inverted so that two choices of decoding are available for employment by decoder 31.

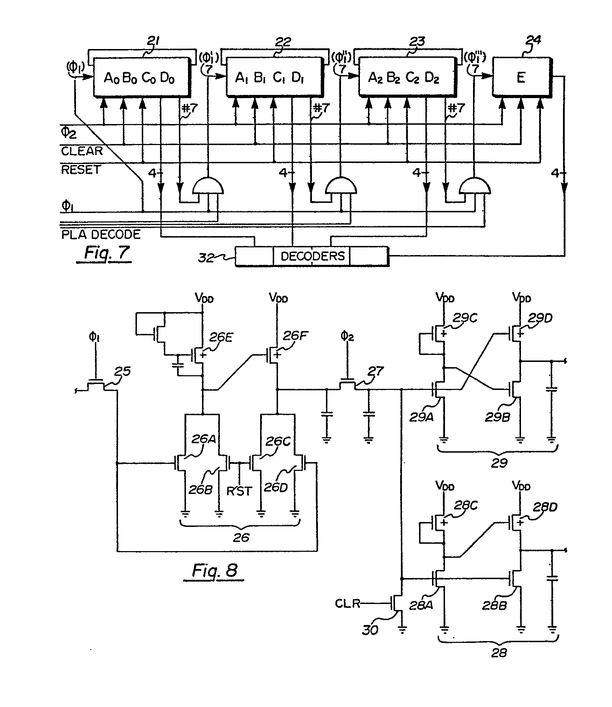

Figure 7 illustrates the basic structure of the counter used in the present invention such that the output of stage 21 will not trigger stage 22 until it has reached a count of 7; stage 22 will not trigger stage 23 until it has reached a count of 7; and stage 23 will not trigger stage 24 until it has reached a count of 7. In this particular arrangement, stage 21 is driven by both phases of a two-stage clock while the remaining stages 22, 23, and 24 are only driven by the second phase of that clock. The stages can be cleared by a clear signal from outside of all the stages and the reset signal which is generated when the counter reaches a count of 779. The final counts are decoded by decoders 32 of Figure 7.

A particular advantage of this type of counting arrangement is that the output of each stage of the respective shift registers can be decoded with only two-bits as was indicated above in Figure 6B. In fact, in the above-listed table, a number of signals have been crossed out as they are not required to decode the pixel counts as required for the timing circuit of the present invention.

When the output of the E stage 24 is true, the counter is in the range of 512 to 779. This true output represents the most significant bit of the octal number being generated by the counter.

One of the advantages of the present invention is that the repetition of the decoded numbers can be employed to reduce the number of bits which are required for decoding. For example, the TIP pulse is to go down or drop at the count of 57. This requires a separate pulse to reset the corresponding flip-flop or cell. However, the pulse at 57 can be repeated from 57 until 779 and only requires the signals $\overline{C_1}$ $D_1$ $A_0$.

For the equalization pulses, EQP, four numbers are required, namely 779, 27, 389 and 417. 27 and 417 could be repeated from 27 to 389 and also 417 to 779. 779 and 389 could be repeated from 779 to 27, and also from 389 to 417. It is to be remembered that from 512 to 779, the E bit is true. Thus 389 is on the lower side of 512 and out of the range of 779, so that it is not necessary to specify the range above 512 for the number 389.

For the decoding of 27 or octal 33, such decoding could be represented by $C_1 C_0$. However $\overline{C_2}$ is also employed to specify octal 33 or $\overline{C_2}$ is employed to represent 0, 1, 2 or 7. With decimal numbers in the range of 0—4, only one digit is required for decoding. For 4—7, $D_0$ is all that is required to decode 4 since D is not required for decoding 0, 1, 2 or 3.

As indicated in Figure 8, each cell is driven by two clock signals $\emptyset_1$ and $\emptyset_2$. However, this is actually only true for the first stage 21 of Figure 7. As indicated Figure 7, $\emptyset_1'$ for stage 22 is the AND product of the $\emptyset_1$ clock signal and the output of stage 21. Similarly, $\emptyset_1''$ is employed to drive stage 23 and is the AND product of $\emptyset_1$ and the output of stage 22. $\emptyset_1'''$ is employed to drive stage 24 and is the AND product of $\emptyset_1$ and the output of stage 23. In addition, each AND gate requires a signal from decoders 32 which is just a set of programmable logic arrays.

The individual cell from which the shift registers of the present invention are formed is illustrated in Figure 8. As was illustrated in Figure 6A, the inverted output from the last cell in the shift register is supplied back to the first cell to get the sequence of signals illustrated in tables of Figure 6B depending upon whether one chooses to use the true outputs for the decode or the inverted outputs. Thus, it will be understood in Figure 8 that the inverted output from the last cell will be supplied back to gate 25 of the first cell to be gated in during clock time $\emptyset_1$. In addition, the true output of output circuit 28 will be supplied to the input of the next cell, and so forth. Output circuit 29 provides the inverse thereof due to the depletion mode nature of certain of the gates. During phase $\emptyset_2$ of the two-phase clock, the state of the cell is transferred to the respective output circuits 28 and 29.

Epilogue

A timing circuit for a digital display has been disclosed above, which circuit includes a series of counters each having four stages such that each counter will drive the next stage only when it has progressed from zero to seven. By reading out the state of each stage of the respective counters, selected counts can be decoded from only two of the respective stage readouts.

**Claims**

1. A timing circuit (19) for controlling a digital display (12, 14), said timing circuit (19) including a counter comprising a plurality of counter stages (21, 22, 23, 34) coupled in series, each of said plurality of counter stages (21, 22, 23, 24) including four commonly-clocked cells (A, B, C, D) coupled in series and each earlier counter stage (21, 22, 23) in the series providing a common clocking signal ($\emptyset_1'$, $\emptyset_1''$, $\emptyset_1'''$) to the next later counter stage (22, 23, 24) in the series only when said earlier counter stage (21, 22, 23) has progressed in its count from zero to seven, said counter further comprising decoding circuitry (32) coupled to receive outputs from said cells (A, B, C, D) in said counter stages (21, 22, 23, 24), said decoding circuitry (32) being required to monitor two outputs from said cells (A, B, C, D) in each counter stage of said counter (21, 22, 23, 24) in order uniquely to decode any one count of said counter, said timing circuit (19) being characterised by said counter being operable to provide a sequence of counts representative of a sequence of positions of a scanning operation along a line of characters in said digital display (12, 14), said decoding circuitry (32) comprising a plurality of decoders, each operable to decode a first respective predetermined count of said counter for setting a respective flip-flop for said respective flip-flop to provide a respective one of a corresponding plurality of control signals (TIP, EQP, VSP, HPIX, HBLANK, HALFLINE) to said display (12, 14) and each decoder being further operable to decode a second respective predetermined count of said counter for resetting said respective flip-flop for said respective flip-flop to cease providing said respective one of said plurality of control signals (TIP, EQP, VSP, HPIX, HBLANK, HALF-LINE) to said display (12, 14), said each decoder of said decoding circuitry (32) being coupled to receive less than said two outputs from cell cells (A, B, C, D) in said each counter stage (21, 22, 23) required uniquely to identify said second respective predetermined count, for said respective flip-flop repeatedly to be reset during the course of said scanning operation without alteration to the function thereof which would be obtained if said second respective predetermined count were uniquely decoded by said respective flip-flop remaining reset after the initial instance of its being reset.

2. A timing circuit (19) according to Claim 1 wherein said decoding circuitry (32) comprises a maximum decoder operable to monitor the count of said counter and to provide an output signal indicative of said counter having reached a maximum count (779) indicative of an extreme terminal position in said scanning operation, said output of said maximum decoder being coupled (RESET) to reset the count of said counter to a count (0) indicative of an extreme initial position in said scanning operation.

3. A timing circuit (19) according to Claim 2 wherein said output signal of said maximum decoder in said decoding circuitry (32) representative of said maximum count (779) is further coupled to set or reset said respective flip-flop for some or for all of said plurality of control signals (TIP, EQP, VSP, HPIX, HBLANK, HALF-LINE).

4. A timing circuit (19) according to any of the preceding claims wherein said counter is coupled to receive a two-phase clock ($\emptyset_1$, $\emptyset_2$) signal, the count of said counter being incrementable for each cycle of said two-phase clock signal ($\emptyset_1$, $\emptyset_2$), each of said counter stages (21, 22, 23, 24) being coupled to receive a first phase ($\emptyset_2$) of said two phase clock signal ($\emptyset_1$, $\emptyset_2$) and the first counter stage (21) in the series being coupled to receive a

second phase ($\emptyset_1$) of said two phase clock signal, where said common clocking signal ($\emptyset_1'$, $\emptyset_1''$, $\emptyset_1'''$) consists in said second phase ($\emptyset_1$) of said two-phase clock signal ($\emptyset_1$, $\emptyset_2$) gated with output from said earlier stage (21, 22, 23) indicative of said earlier stage being at a count of seven.

5. A timing circuit according to Claim 4 characterised by said common clocking signal ($\emptyset_1'$, $\emptyset_1''$, $\emptyset_1'''$) further being gated with individual control signals (PLA DECODE) for controlling the incrementing of each individual counter stage (21, 22, 23, 24) in the series of counter stages.

6. A method for controlling a digital display (12, 14), said method including the use of a counter comprising a plurality of counter stages (21, 22, 23, 24) coupled in series, each of said plurality of counter stages (21, 22, 23, 24) including four commonly-clocked cells (A, B, C, D) coupled in series and each earlier counter stage (21, 22, 23) in the series providing a common clocking signal ($\emptyset_1'$, $\emptyset_1''$, $\emptyset_1'''$) to the next later counter stage (22, 23, 24) in the series only when said earlier counter stage (21, 22, 23) has progressed in its count from zero to seven, said counter further comprising decoding circuitry (32) coupled to receive outputs from said cells (A, B, C, D) in said counter stages (21, 22, 23, 24), said decoding circuitry (32) being required to monitor two outputs from said cells (A, B, C, D) in each counter stage of said counter (21, 22, 23, 24) in order uniquely to decode any one count of said counter, said method being characterised by said counter being operable to provide a sequence of counts representative of a sequence of positions of a scanning operation along a line of characters in said digital display (12, 14), said decoding circuitry (32) comprising a plurality of decoders, each operable to decode a first respective predetermined count of said counter for setting a respective flip-flop for said respective flip-flop to provide a respective one of a corresponding plurality of control signals (TIP, EQP, VSP, HPIX, HBLANK, HALF-LINE) to said display (12, 14) and each decoder being further operable to decode a second respective predetermined count of said counter for resetting said respective flip-flop for said respective flip flop to cease providng said respective one of said plurality of control signals (TIP, EQP, VSP, HPIX, HBLANK, HALF-LINE) to said display (12, 14), said each decoder of said decoding circuitry (32) being coupled to receive less than said two outputs from said cells (A, B, C, D) in said each counter stage (21, 22, 23) required uniquely to identify said second respective predetermined count, for said respective flip-flop repeatedly to be reset during the course of said scanning operation without alteration of the function thereof which would be obtained if said second respective predetermined number were uniquely decoded by said respective flip-flop remaining reset after the initial instance of it being reset.

7. A method according to Claim 6 wherein said decoding circuitry (32) comprises a maximum decoder operable to monitor the count of said counter and to provide an output signal indicative of said counter having reached a maximum count (779) indicative of an extreme terminal position in said scanning operation, said output of said maximum decoder being coupled (RESET) to reset the count of said counter to a count (0) indicative of an extreme initial position in said scanning operation.

8. A method according to Claim 7 wherein said output signal of said maximum decoder in said decoding circuitry (32) representative of said maximum count (779) is further coupled to set or reset said respective flip-flop for some or for all of said plurality of control signals (TIP, EQP, VSP, HPIX, HBLANK, HALF-LINE).

9. A method according to any of Claims 6 to 8 wherein said counter is coupled to receive a two-phase clock ($\emptyset_1$, $\emptyset_2$) signal, the count of said counter being incrementable for each cycle of said two-phase clock signal ($\emptyset_1$, $\emptyset_2$), each of said counter stages (21, 22, 23, 24) being coupled to receive a first phase ($\emptyset_2$) of said two phase clock signal ($\emptyset_1$, $\emptyset_2$) and the first counter stage (21) in the series being coupled to receive a second phase ($\emptyset_1$) of said two phase clock signal, where said common clocking signal ($\emptyset_1'$, $\emptyset_1''$, $\emptyset_1'''$) consists in said second phase ($\emptyset_1$) of said two-phase clock signal ($\emptyset_1$, $\emptyset_2$) gated with output from said earlier stage (21, 22, 23) indicative of said earlier stage being at a count of seven.

10. A method according to Claim 9 wherein said common clocking signal ($\emptyset_1'$, $\emptyset_1''$, $\emptyset_1'''$) is further gated with individual control signals (PLA DECODE) for controlling the incrementing of each individual counter stage (21, 22, 23, 24) in the series of counter stages.

## Revendications

1. Circuit de minuterie (19) pour commander un dispositif d'affichage numérique (12, 14), ce circuit de minuterie (19) comportant un compteur formé d'un ensemble d'étages de compteur (21, 22, 23, 24) branchés en série, chacun des ensemble d'étages de compteur (21, 22, 23, 24) comprenant quatre cellules commandées en cadence en commun (A, B, C), couplées en série et chaque étage de compteur précédent (21, 22, 23) de la série donnant un signal d'horloge commun ($\emptyset_1'$, $\emptyset_1''$, $\emptyset_1'''$) à l'étage de comptage directement suivant (22, 23, 24) dans la série seulement lorsque l'étage de comptage antérieur (21, 22, 23) a progressé dans son comptage de zéro à sept, ce compteur comportant en outre un circuit de décodage (32) couplé de façon à recevoir les signaux de sortie des cellules (A, B, C, D) des étages de compteur (21, 22, 23, 24), ce circuit de décodage (32) étant nécessaire pour contrôler deux sorties des cellules (A, B, C, D) dans chaque étage de compteur du compteur (21, 22, 23, 24) dans un ordre unique pour décoder n'importe quel comptage du compteur, ce circuit de minuterie (19) étant caractérisé en ce que le compteur peut fonctionner pour fournir une suite d'états de comptage représentant une séquence de position d'une opération de balayage suivant une ligne de caractères dans l'affichage numérique (12, 14), ce circuit de décodage (32) comportant un ensemble de décodeurs, chacun fonctionnant pour décoder un premier état de comptage respectif, prédéterminé du compteur pour mettre à l'état un flip-flop respectif pour que ce flip-flop respectif donne l'un des différents signaux de commande correpondants (TIP, EQP, VSP, HPIX, HBLANK, HALF-LINE) au dispositif d'affichage (12, 14) et chaque décodeur pouvant en outre décoder un second comptage prédéterminé respectif du compteur pour remettre à l'état initial le flip-flop respectif pour que le flip-flop respectif arrête de fournir le signal respectif parmi l'ensemble des signaux de commande (TIP, EQP, VSP, HPIX, HBLANK, HALF-LINE) au dispositif d'affichage (12, 14), chaque décodeur du circuit de décodage (32) étant couplé de façon à recevoir moins de deux sorties des cellules (A, B, C, D) dans chaque étage de compteur (21, 22, 23) nécessaire pour identifier le second comptage prédéterminé respectif, pour que le flip-flop respectif soit remis à l'état initial de façon répétée au cours de l'opération de balayage sans modification de sa fonctions que l'on aurait si le second état de comptage prédéterminé respectif était uniquement décodé par le flip-flop respectif, restant, remis à l'état initial après sa première remiste à l'état initial.

2. Circuit de minuterie (19) selon la revendication 1, caractérisé en ce que le circuit de décodage (32) se compose d'un décodeur de maximum contrôlant le comptage du compteur et donnant un signal de sortie indiquant que le compteur est arrivé à son état de comptage maximum (779) indiquant une position finale extrême dans l'opération de balayage, la sortie du décodeur de maximum étant couplée (RESET) pour remettre à l'état initial l'état de comptage du compteur sur un état de comptage (0) indiquant une position initiale extrême dans l'opération de balayage.

3. Circuit de minuterie (19) selon la revendication 2, dans lequel le signal de sortie du décodeur de maximum du circuit de décodage (32) représentant l'état de comptage maximum (779) est en outre couplé pour mettre à l'état ou remettre à l'état initial le flip-flop respectif pour certaines ou tous les signaux de commande (TIP, EQP, VSP, HPIX, HBLANK, HALF-LINE).

4. Circuit de minuterie (19) selon l'une quelconque des revendications précédentes, caractérisé en ce que le compteur est couplé de façon à recevoir un signal d'horloge biphase ($\emptyset_1$, $\emptyset_2$), le comptage du compteur pouvant être incrémenté pour chaque cycle du signal d'horloge biphase ($\emptyset_1$, $\emptyset_2$), chacun des étages de compteur (21, 22, 23, 24) étant couplé de façon à recevoir une première phase ($\emptyset_2$) du signal d'horloge biphase ($\emptyset_1$, $\emptyset_2$) et le premier étage de compteur (21) de la série étant couplé de façon à recevoir une seconde phase ($\emptyset_1$) du signal d'horloge biphase, le signal d'horloge commun ($\emptyset_1'$, $\emptyset_1''$, $\emptyset_1'''$) se composant d'une seconde phase ($\emptyset_1$) du

signal d'horloge biphase ($\emptyset_1$, $\emptyset_2$) commandé en porte par la sortie de l'étage précédent (21, 22, 23) indiquant que cet étage précédent est à l'état de comptage sept.

5. Circuit de minuterie selon la revendication 4, caractérisé en ce que le signal d'horloge commun ($\emptyset_1'$, $\emptyset_1''$, $\emptyset_1'''$) est en outre commandé en porte par des signaux de commande individuels (PLA, DECODE), pour commander l'incrémentation de chaque étage distinct du compteur (21, 22, 23, 24) de la série des étages de compteur.

6. Procédé pour commander un dispositif d'affichage numérique (12, 14) ce procédé comprenant l'utilisation d'un compteur ayant un ensemble d'étages de compteur (21, 22, 23, 24) couplés en série, chacun des ensembles d'étages de compteur (21, 22, 23, 24) ayant quatre cellules commandées en cadence en commun (A, B, C, D), cellules couplées en série et chaque étage de compteur antérieur (21, 22, 23) de la série donne un signal d'horloge commun ($\emptyset_1'$, $\emptyset_1''$, $\emptyset_1''$) vers l'étage de compteur directement suivant (22, 23, 24) de la série seulement lorsque l'étage de compteur antérieur (21, 22, 23) a progressé dans sont comptage de zéro à sept, ce compteur comportant en outre un circuit de décodage (32) couplé de façon à recevoir les sorties des cellules (A, B, C, D) des étages de compteur (21, 22, 23, 24), ce circuit de décodage (32) étant nécessaire pour contrôler deux sorties des cellules (A, B, C, D) de chaque étage de compteur du compteur (21, 22, 23, 24) pour décoder uniquement l'un des comptages du compteur, ce procédé étant caractérisé en ce que le compteur peut fournir une séquence de comptage représentant une séquence de position d'une opération de balayage suivant une ligne de caractères dans l'affichage numérique (12, 14), ce circuit de décodage (32) comportant un ensemble de décodeurs chacun pouvant travailler pour décoder un premier comptage prédéterminé respectif du compteur pour mettre à l'état un flip-flop respectif pour que ce flip-flop respectif fournisse l'un des signaux de commande parmi l'ensemble des signaux (TIP, EQP, VSP, HPIX, HBLANK, HALF-LINE) au dispositif d'affichage (12, 14) et chaque décodeur pouvant en outre décoder un second comptage prédéterminé respectif du compteur pbur remettre à l'état initial le flip-flop respectif pour que le flip-flop respectif s'arrête de fournir le signal respectif parmi l'ensemble des signaux de commande (TIP, EQP, VSP, HPIX, HBLANK, HALF-LINE) au dispositif d'affichage (12, 14), ce décodeur du circuit de décodage (32) étant couplé de façon à recevoir moins que les deux sorties des cellules (A, B, C, D) dans chaque étage de compteur (21, 22, 23) nécessaire uniquement pour identifier le second comptage prédéterminé respectif pour mettre de façon répétée le flip-flop respectif à l'état initial au cours de l'opération de balayage sans modifier sa fonction que l'on obtiendrait si le second nombre prédéterminé respectif était uniquement décodé si le flip-flop respectif restait remis à l'état initial après avoir été une première fois remis à l'état initial.

7. Procédé selon la revendication 6, caractérisé en ce que le circuit de décodage (32) comporte un décodeur de maximum contrôlant le comptage du compteur et fournissant un signal de sortie indiquant que le compteur est arrivé à un comptage maximum (779) correspondant à une position finale extrême dans l'opération de balayage, cette sortie du décodeur de maximum étant couplée (RESET) de façon à remettre à l'état initial le comptage du compteur sur l'état de comptage (0) indiquant une position initiale extrême dans cette opération de balayage.

8. Procédé selon la revendication 7, caractérisé en ce que le signal de sortie du décodeur de maximum du circuit de décodage (32) représentant l'état de comptage maximum (779) est en outre couplé de façon à mettre à l'état ou à remettre à l'état initial le flip-flop respectif pour certains ou tous les signaux de commande parmi l'ensemble (TIP, EQP, VSP, HPIX, HBLANK, HALF-LINE).

9. Procédé selon l'une quelconque des revendications 6 à 8, caractérisé en ce que le compteur est couplé de façon à recevoir un signal d'horloge biphase ($\emptyset_1$, $\emptyset_2$), l'état de comptage du compteur pouvant être incrémenté pour chaque cycle du signal d'horloge biphase ($\emptyset_1$, $\emptyset_2$), chacun des étages de compteur (21, 22, 23, 24) étant couplé de façon à recevoir une première phase ($\emptyset_2$) du signal d'horloge biphase ($\emptyset_1$, $\emptyset_2$) et le premier étage de compteur (21) de la série étant couplé de façon à recevoir une seconde phase ($\emptyset_1$) du signal d'horloge biphase, le signal d'horloge commun ($\emptyset_1'$, $\emptyset_1''$, $\emptyset_1'''$) se composant de la seconde phase ($\emptyset_1$) du signal d'horloge biphase ($\emptyset_1$, $\emptyset_2$) commandé en porte par la sortie de l'étage antérieur (21, 22, 23) indiquant que cet étage antérieur avait un état de comptage égal à sept.

10. Procédé selon la revendication 9, caractérisé en ce que le signal d'horloge commun ($\emptyset_1'$, $\emptyset_1''$, $\emptyset_1'''$) est en outre commandé en porte avec des signaux de commande individuels (PLA DECODE) pour commander l'incrémentation de chaque étage de compteur individuel (21, 22, 23, 24) de la série des étages de compteur.

**Patentansprüche**

1. Zeitgeberschaltung (19) zur Steuerung einer Digitalanzeige (12, 14) mit einem in der Zeitgeberschaltung (19) enthaltenen Zähler, der mehrere in Reihe geschaltete Zählerstufen (21, 22, 23, 24) aufweist, von denen jede Zählerstufe (21, 22, 23, 24) vier gemeinsam getaktete, in Reihe geschaltete Zellen (A, B, C, D) enthält, von denen jede vorangehende Zählerstufe (21, 22, 23) in der Reihenschaltung eine gemeinsames Taktsignal ($\emptyset_1'$, $\emptyset_1''$, $\emptyset_1'''$) an die nächstfolgende Zählerstufe (22, 23, 24) der Reihenschaltung nur abgibt, wenn die vorangehende Zählerstufe (21, 22, 23) in ihrer Zählung von 0 bis 7 fortgeschritten ist, wobei der Zähler zusätzlich einen Dekodierschaltkreis (32) enthält, der mit den Ausgängen der Zellen (A, B, C, D) in den Zählerstufen (21, 22, 23, 24) verbunden ist und der Dekodierschaltkreis (32) zwei Ausgänge der Zellen (A, B, C, D) in jeder Zählerstufe (21, 22, 23, 24) des Zählers überwacht um jeden einzelnen Zählerstand des Zählers zu dekodieren, dadurch gekennzeichnet, daß der Zähler eine Zählfolge abgibt, die eine Folge von Positionen einer Abtastoperation entlang einer Zeichenzeile der Digitalanzeige (12, 14) repräsentiert, daß der Dekodierschaltkreis (32) mehrere Dekodierer enthält, von denen jeder einen ersten entsprechend vorbestimmten Zählerstand des Zählers zum Setzen eines entsprechenden Flip-Flops dekodiert, damit das betreffende Flip-Flop jeweils eines von entsprechend mehreren Steuersignalen (TIP, EQP, VSP, HPIX, HBLANK, HALF-LINE) an die Digitalanzeige (12, 14) abgibt und jeder Dekodierer einen zweiten entsprechend vorbestimmten Zählerstand des Zählers zum Rücksetzen des entsprechenden Flip-Flops dekodiert, damit das betreffende Flip-Flop die Abgabe des entsprechenden Steuersignals der mehreren Steuersignale (TIP, EQP, VSP, HPIX, HBLANK, HALF-LINE) an die Digitalanzeige (12, 14) einstellt, und daß jeder Dekodierer des Dekodierschaltkreises (32) weniger als die beiden Ausgänge der Zellen (A, B, C, D) in jeder der Zählerstufen (21, 22, 23) empfängt, die zur Identifizierung des zweiten entsprechend vorbestimmten Zählerstandes erforderlich sind, um das entsprechende Flip-Flop wiederholt während des Verlaufes der Abtastoperation zurückzusetzen, ohne eine Änderung der Funktion, die erzielt werden würde, wenn der zweite entsprechend vorbestimmte Zählerstand allein durch das entsprechende Flip-Flop dekodiert würde, das zurückgesetzt bleibt, nachdem es anfänglich zurückgesetzt wurde.

2. Zeitgeberschaltung (19) nach Anspruch 1, dadurch gekennzeichnet, daß der Dekodierschaltkreis (32) einen Maximumdekodierer enthält, der den Zählerstand des Zählers überwacht und eine Ausgangssignal abgibt, das anzeigt, daß der Zähler einen maximalen Zählerstand erreicht hat, der eine extreme Endstellung der Abtastoperation angibt, wobei der Ausgang des Maximumdekodierers den Zählerstand des Zählers auf einen Zählerstand (0) zurücksetzt (RESET), der eine extreme Ausgangsstellung der Abtastoperation angibt.

3. Zeitgeberschaltung (19) nach Anspruch 2, dadurch gekennzeichnet, daß das Ausgangssignal des Maximumdekodierers im Dekodierschaltkreis (32), das den maximalen Zählerstand (779) repräsentiert, weiterhin dazu dient, das entsprechende Flip-Flop für einige oder für alle der mehreren Steuersignale (TIP, EQP, VSP, HPIX, HBLANK, HALF-LINE) zu setzen oder zurückzusetzen.

4. Zeitgeberschaltung (19) nach einem der vorstehenden Ansprüche, dadurch gekennzeichnet, daß der Zähler mit einem Zwei-Phasen-Taktsignal ($\emptyset_1$, $\emptyset_2$) beaufschlagt ist, daß der Zählerstand des Zählers für jeden Zyklus des Zwei-Phasen-Taktsignals ($\emptyset_1$, $\emptyset_2$) inkrementierbar

ist, und daß jede der Zählerstufen (21, 22, 23, 24) mit einer ersten Phase ($Ø_2$) des Zwei-Phasen-Taktsignals ($Ø_1$, $Ø_2$) und die erste Zählerstufe (21) in der Reihenschaltung mit einer zweiten Phase ($Ø_1$) des Zwei-Phasen-Taktsignales beaufschlagt ist, wobei das gemeinsame Taktsignal ($Ø_1'$, $Ø_1''$, $Ø_1'''$) in der zweiten Phase ($Ø_1$) des Zwei-Phasen-Taktsignals ($Ø_1$, $Ø_2$) besteht, das mit dem Ausgang der vorangehenden Stufe (21, 22, 23), das anzeigt, daß die vorangehende Stufe bei einem Zählerstand 7 angelangt ist, verknüpft wird.

5. Zeitgeberschaltung nach Anspruch 4, dadurch gekennzeichnet, daß das gemeinsame Taktsignal ($Ø_1'$, $Ø_1''$, $Ø_1'''$) darüber hinaus mit individuellen Steuersignalen (PLA DECODE) zur Steuerung der Inkrementierung jeder individuellen Zählerstufe (21, 22, 23, 24) in der Reihenschaltung der Zählerstufen verknüpft ist.

6. Verfahren zur Steuerung einer Digitalanzeige (12, 14) mit einem in der Zeitgeberschaltung (19) enthaltenen Zähler, der mehrere in Reihe geschaltete Zählerstufen (21, 22, 23, 24) aufweist, von denen jede Zählerstufe (21, 22, 23, 24) vier gemeinsam getaktete, in Reihe geschaltete Zellen (A, B, C, D) enthält, von denen jede vorangehende Zählerstufe (21, 22, 23) in der Reihenschaltung ein gemeinsames Taktsignal ($Ø_1'$, $Ø_1''$, $Ø_1'''$) an die nächstfolgende Zählerstufe (22, 23, 24) der Reihenschaltung nur abgibt, wenn die vorangehende Zählerstufe (21, 22, 23) in ihrer Zählung von 0 bis 7 fortgeschritten ist, wobei der Zähler zusätzlich einen Dekodierschaltkreis (32) enthält, der mit den Ausgängen der Zellen (A, B, C, D) in den Zählerstufen (21, 22, 23, 24) verbunden ist und der Dekodierschaltkreis (32) zwei Ausgänge der Zellen (A, B, C, D) in jeder Zählerstufe (21, 22, 23, 24) des Zählers überwacht um jeden einzelnen Zählerstand des Zählers zu dekodieren, dadurch gekennzeichnet, daß der Zähler eine Zählfolge abgibt, die eine Folge von Positionen einer Abtastoperation entlang einer Zeichenzeile der Digitalanzeige (12, 14) repräsentiert, daß der Dekodierschaltkreis (32) mehrere Dekodierer enthält, von denen jeder einen ersten entsprechend vorbestimmten Zählerstand des Zählers zum Setzen eines entsprechenden Flip-Flops dekodiert, damit das betreffende Flip-Flop jeweils eines von entsprechend mehreren Steuersignalen (TIP, EQP, VSP, HPIX, HBLANK, HALF-LINE) an die Digitalanzeige (12, 14) abgibt und jeder Dekodierer einen zweiten entsprechend vorbestimmten Zählerstand des Zählers zum Rücksetzen des entsprechenden Flip-Flops dekodiert, damit das betreffende Flip-Flop die Abgabe des entsprechenden Steuersignals der mehreren Steuersignale (TIP, EQP, VSP, HPIX, HBLANK, HALF-LINE) an die Digitalanzeige (12, 14) beendet, und daß jeder

Dekodierer des Dekodierschaltkreises (32) weniger als die beiden Ausgänge der Zellen (A, B, C, D) in jeder der Zählerstufen (21, 22, 23) empfängt, die zur Identifizierung des zweiten entsprechend vorbestimmten Zählerstandes erforderlich sind, um das entsprechende Flip-Flop wiederholt während des Verlaufes der Abtastoperation zurückzusetzen, ohne eine Änderung der Funktion, die erzielt werden würde, wenn der zweite entsprechend vorbestimmte Zählerstand allein durch das entsprechende Flip-Flop dekodiert würde, das zurückgesetzt bleibt, nachdem es zu Beginn zurückgesetzt wurde.

7. Verfahren nach Anspruch 6, dadurch gekennzeichnet, daß der Dekodierschaltkreis (32) einen Maximumdekodierer enthält, der den Zählerstand des Zählers überwacht und ein Ausgangssignal abgibt, das anzeigt, daß der Zähler einen maximalen Zählerstand erreicht hat, der eine extreme Endstellung der Abtastoperation angibt, wobei der Ausgang des Maximumdekodierers den Zählerstand des Zählers auf einen Zählerstand (0) zurücksetzt (RESET), der eine extreme Ausgangsstellung der Abtastoperation angibt.

8. Verfahren nach Anspruch 7, dadurch gekennzeichnet, daß das Ausgangssignal des Maximumdekodierers im Dekodierschaltkreis (32), das den maximalen Zählerstand (779) repräsentiert, weiterhin dazu dient, das entsprechende Flip-Flop für einige oder für alle der mehreren Steuersignale (TIP, EQP, VSP, HPIX, HBLANK, HALF-LINE) zu setzen oder zurückzusetzen.

9. Verfahren nach einem der Ansprüche 6 bis 8, dadurch gekennzeichnet, daß der Zähler mit einem Zwei-Phasen-Taktsignal ($Ø_1$, $Ø_2$) beaufschlagt ist, daß der Zählerstand des Zählers für jeden Zyklus des Zwei-Phasen-Taktsignals ($Ø_1$, $Ø_2$) inkrementierbar ist, und daß jede der Zählerstufen (21, 22, 23, 24) mit einer ersten Phase ($Ø_2$) des Zwei-Phasen-Taktsignals ($Ø_1$, $Ø_2$) und die erste Zählerstufe (21) in der Reihenschaltung mit einer zweiten Phase ($Ø_1$) des Zwei-Phasen-Taktsignales beaufschlagt ist, wobei das gemeinsame Taktsignal ($Ø_1'$, $Ø_1''$, $Ø_1'''$) in der zweiten Phase ($Ø_1$) des Zwei-Phasen-Taktsignals ($Ø_1$, $Ø_2$) besteht, das mit dem Ausgang der vorangehenden Stufe (21, 22, 23), das anzeigt, daß die vorangehende Stufe bei einem Zählerstand 7 angelangt ist, verknüpft wird.

10. Verfahren nach Anspruch 9, dadurch gekennzeichnet, daß das gemeinsame Taktsignal ($Ø_1'$, $Ø_1''$, $Ø_1'''$) darüber hinaus mit individuellen Steuersignalen (PLA DECODE) zur Steuerung der Inkrementierung jeder individuellen Zählerstufe (21, 22, 23, 24) in der Reihenschaltung der Zählerstufen verknüpft wird.

*Fig. 1*

*Fig. 4*

_Fig. 2C_

_Fig. 2B_

15F
15E
15D
15C
15B
15A

_Fig. 2A_

_Fig. 3_

_Fig. 5_

0 057 314

Fig. 6A

| | A B C D | DECODE | | A B C D | DECODE |
|---|---|---|---|---|---|
| 0 | 0 0 0 0 | $\overline{A}$ $\overline{D}$ | 0 | 1 1 1 1 | A D |
| 1 | 1 0 0 0 | A $\overline{B}$ | 1 | 0 1 1 1 | $\overline{A}$ B |
| 2 | 1 1 0 0 | B $\overline{C}$ | 2 | 0 0 1 1 | $\overline{B}$ C |
| 3 | 1 1 1 0 | C $\overline{D}$ | 3 | 0 0 0 1 | $\overline{C}$ D |
| 4 | 1 1 1 1 | A D | 4 | 0 0 0 0 | $\overline{A}$ $\overline{D}$ |
| 5 | 0 1 1 1 | $\overline{A}$ B | 5 | 1 0 0 0 | A $\overline{B}$ |
| 6 | 0 0 1 1 | $\overline{B}$ C | 6 | 1 1 0 0 | B $\overline{C}$ |
| 7 | 0 0 0 1 | $\overline{C}$ D | 7 | 1 1 1 0 | C $\overline{D}$ |

Fig. 6B

4

# 0 057 314

*Fig. 7*

*Fig. 8*